# EUROPEAN PATENT APPLICATION

(11) **EP 4 797 536 A1**
(43) Date of publication of application: **26.08.2026**
(21) Application number: 25216954.5
(22) Date of filing: 19.11.2025
(51) Int. Cl.: H03M 1/06, H03M 1/10, H03M 1/46

(54) **ANALOG-TO-DIGITAL CONVERTER AND CONVERSION METHOD**

(30) Priority: 19.02.2025 KR 20250021639
(71) Applicant: Korea University Research and Business Foundation, Seoul 02841 (KR)
(72) Inventor: KIM, Chulwoo, 06276 Seoul (KR); KIM, Changjoo, 08090 Seoul (KR); PARK, Sooho, 02843 Seoul (KR); CHOI, Yohan, 02776 Seoul (KR)
(74) Representative: RGTH

(57) **Abstract**

The present disclosure relates to an analog-to-digital converter and a conversion method, and more particularly, to an analog-to-digital converter and a conversion method for reducing a clock cycle required for conversion by increasing a conversion resolution in a characteristic clock cycle. According to an embodiment of the present disclosure, a method of operating an analog-to-digital converter for converting an analog input signal into a digital output in response to a clock cycle may include sampling the analog input signal and inputting the sampled analog input signal to each of a first comparator, a second comparator, and a third comparator, obtaining a first digital output including two bits based on a first output value output as first comparison voltages having a first interval are applied to the first comparator to the third comparator during a first clock cycle, obtaining a second output value by applying second comparison voltages having a second interval smaller than the first interval to the first comparator to the third comparator within a preset range during a second clock cycle, and obtaining a second digital output including three bits based on the second output value when the second output value has a value within the range.

## Description

### [Technical Field]

The present disclosure relates to an analog-to-digital converter and a conversion method, and more particularly, to an analog-to-digital converter and a conversion method for reducing a clock cycle required for conversion by increasing a conversion resolution in a characteristic clock cycle.

### [Background of the Invention]

A successive approximation register (SAR) type analog-to-digital converter, which is one of high-speed analog-to-digital converters commonly used in the wired or wireless communication system field, may generate a digital bit by sequentially comparing an analog input signal in units of one clock.

Such an analog-to-digital converter may include a plurality of comparators. However, when a difference in offset occurs between a plurality of comparators, the performance of the analog-to-digital converter may be reduced.

Accordingly, there is a need to correct the difference in offset between comparators. However, as an additional clock cycle is required to correct the difference in offset between the comparators, the operation time of the analog-to-digital converter may increase.

### [Summary of Invention]

### [Problems to be Solved]

An object of the present invention is to provide an analog-to-digital conversion method for reducing the time required for analog-to-digital conversion by increasing the resolution of analog-to-digital conversion in a specific clock cycle.

An object of the present invention is to provide an analog-to-digital conversion method capable of omitting a separate correction for correcting the offset of an analog-to-digital converter by correcting the offset of each comparator.

### [Means for solving problems]

According to an embodiment of the present disclosure, a method of operating an analog-to-digital converter for converting an analog input signal into a digital output in response to a clock cycle may include sampling the analog input signal and inputting the sampled analog input signal to each of a first comparator, a second comparator, and a third comparator, obtaining a first digital output including two bits based on a first output value output as first comparison voltages having a first interval are applied to the first comparator to the third comparator during a first clock cycle, obtaining a second output value by applying second comparison voltages having a second interval smaller than the first interval to the first comparator to the third comparator within a preset range during a second clock cycle, and obtaining a second digital output including three bits based on the second output value when the second output value has a value within the range.

The obtaining of the first digital output during the first clock cycle may further include: applying a first comparison voltage (1) to the first comparator, applying a first comparison voltage (2) having the first interval from the first comparison voltage (1) to the second comparator, and applying a first comparison voltage (3) having the first interval from the first comparison voltage (2) to the third comparator; and obtaining the first digital output corresponding to the first output value including comparison results output from the first comparator to the third comparator, wherein the first interval may have a value equal to 1/4 of a power supply voltage.

According to an embodiment, the obtaining of the second digital output during the second clock cycle may further include: applying a second comparison voltage (1) to the first comparator, applying a second comparison voltage (2) to the second comparator, and applying a second comparison voltage (3) to the third comparator; and obtaining the second digital output corresponding to the second output value including comparison results output from the first comparator to the third comparator, wherein the second interval may have a value equal to 1/8 of the power supply voltage.

The method may further include correcting an offset of at least one of the first comparator to the third comparator during a third clock cycle, in response to obtaining the second digital output during the second clock cycle.

According to an embodiment, the correcting of the offset of at least one of the first comparator to the third comparator may further include: applying a common mode voltage to each of the first comparator to the third comparator; and when the first comparator outputs a predetermined error value, further applying a correction voltage to the first comparator such that the first comparator outputs a predetermined normal value.

According to an embodiment, the method may further include, when the second output value has a value outside the range, applying third comparison voltages having the first interval to each other to the first comparator to the third comparator during the third clock cycle, and determining a third digital output including three bits based on a third output value output from the first comparator to the third comparator during the third clock cycle and the second output value.

According to an embodiment, the analog-to-digital converter includes a first comparator, a second comparator, a third comparator, and a control logic circuit configured to output a digital output from an analog input signal using the first comparator to the third comparator based on a clock cycle, wherein the control logic circuit is configured to obtain a first digital output including two bits based on a first output value output as first comparison voltages having a first interval are applied to the first comparator to the third comparator during a first clock cycle, obtain a second digital output including three bits based on the second output value when a second output value output as second comparison voltages having a second interval smaller than the first interval are applied to the first comparator to the third comparator within a predetermined range during a second clock cycle, and, in response to obtaining the second digital output during the second clock cycle, an offset of at least some of the first comparator to the third comparator may be corrected during a third clock cycle.

According to an embodiment, the first interval may have a value equal to 1/4 of the power supply voltage, and the second interval may have a value equal to 1/8 of the power supply voltage.

According to an embodiment, when the second output value has a value outside the range, the control logic circuit may apply third comparison voltages having the first interval to the first comparator to the third comparator during the third clock cycle, and obtain a third digital output including three bits, based on a third output value output as the third comparison voltages are applied, and the second output value.

According to an embodiment, the control logic circuit may apply a common mode voltage to each of the first comparator to the third comparator during the third clock cycle in response to obtaining the second digital output during the second clock cycle, and may further apply a correction voltage to the first comparator such that the first comparator outputs a predetermined normal value when the first comparator outputs a predetermined error value.

### [Effects of Invention]

The analog-to-digital converter and the conversion method of the present invention can reduce the time required to convert an analog input signal into a digital signal.

### [Brief Description of Drawings]

FIG. 1 is a block diagram illustrating a configuration of an analog-to-digital converter according to an embodiment of the present invention.
FIG. 2 is a block diagram illustrating an analog-to-digital converter further including a plurality of DAC according to an embodiment.
FIG. 3 illustrates a configuration in which a control logic circuit according to an embodiment obtains a first output value during a first clock cycle.
FIG. 4 illustrates a configuration in which a control logic circuit according to an embodiment obtains a second output value during a second clock cycle.
FIG. 5 illustrates a configuration in which a control logic circuit outputs a digital signal including a first digital output and a second digital output when a second output value has a value within a preset range according to an embodiment.
FIG. 6 illustrates a configuration in which a control logic circuit according to an embodiment applies a common mode voltage to each of a first comparator to a third comparator during a third clock cycle.
FIG. 7 illustrates a configuration for correcting an offset of a first comparator based on a correction output value output from the first comparator according to an embodiment.
FIG. 8 illustrates a configuration in which a control logic circuit obtains a third output value during a third clock cycle when a second output value has a value outside a preset range according to an embodiment.
FIG. 9 illustrates a configuration in which a control logic circuit according to an embodiment outputs a digital signal based on a second output value and a third output value.
FIG. 10 is a flowchart illustrating a method of operating an analog-to-digital converter according to an embodiment.
FIG. 11 is a flowchart illustrating a method of correcting an offset of at least one of a first comparator to a third comparator during a third clock cycle according to an embodiment.
FIG. 12 is a flowchart illustrating a more specific method of correcting an offset of at least one of a first comparator to a third comparator during a third clock cycle according to an embodiment.

### [Details for Carrying Out the Invention]

Hereinafter, the present disclosure will be described with reference to the accompanying drawings. The present disclosure may make various changes and may have various embodiments, such that specific embodiments are illustrated in the drawings and related detailed descriptions are described. However, this is not intended to limit the present disclosure to a specific embodiment, and it should be understood that the present disclosure includes all changes and/or equivalents or substitutes included in the spirit and technical scope of the present disclosure. With respect to the description of the drawings, similar reference numerals are used for similar components.

Expressions such as "include" or "may include" that may be used in the present disclosure refer to the presence of the corresponding function, operation, or component disclosed, and do not limit additional one or more functions, operations, or components. In addition, in the present disclosure, it should be understood that terms such as "include" or "have" are intended to designate the presence of features, numbers, steps, operations, components, parts described in the specification, or a combination thereof, and do not preclude the presence or addition of one or more other features, numbers, steps, operations, components, parts, or a combination thereof.

Expressions such as "or" in the present disclosure include any, and all combinations of words listed together. For example, "A or B" may include A, may include B, or may include both A and B.

Expressions such as "first," or "second," among the present disclosure may modify various elements of the present disclosure, but do not limit those elements. For example, the expressions do not limit the order and/or importance of the corresponding components. The above expressions may be used to distinguish one component from another. For example, both the first user device and the second user device are user devices, and represent different user devices. For example, without departing from the scope of the disclosure, a first component may be referred to as a second component, and similarly, a second component may also be referred to as a first component.

When a component is referred to as being "connected" or "coupled" to another component, it should be understood that the component may be directly connected or coupled to the other component, but another component may exist in the middle. On the other hand, when a component is referred to as being "directly connected" or "directly coupled" to another component, it should be understood that the other component does not exist in the middle.

The terms used in the disclosure are used only to describe specific embodiments, and are not intended to limit the disclosure. Singular expressions include plural expressions unless the context clearly indicates otherwise.

Unless otherwise defined, all terms used herein, including technical or scientific terms, have the same meaning as those generally understood by those of ordinary skill in the art to which the present disclosure pertains. Terms such as those defined in commonly used dictionaries should be interpreted as having a meaning consistent with the meaning in the context of the related art, and unless clearly defined in the present disclosure, they are not interpreted as ideal or excessively formal meanings.

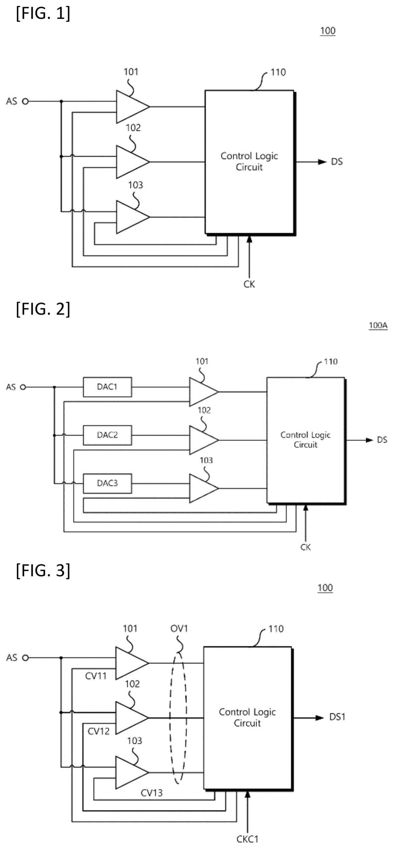

FIG. 1 is a block diagram illustrating a configuration of the analog-to-digital converter according to an embodiment of the present invention. FIG. 2 is a block diagram illustrating the analog-to-digital converter further including a plurality of DAC according to an embodiment.

Referring to FIG. 1, the analog-to-digital converter 100 according to an embodiment may include a first comparator 101, a second comparator 102, a third comparator 103, and a control logic circuit 110.

Referring to FIG. 2, the analog-to-digital converter 100A according to an embodiment may include a first DAC (DAC1), a second DAC (DAC2), and a third DAC (DAC3).

More specifically, the analog-to-digital converter 100A may include a first DAC (DAC1) connected to the first comparator 101. In addition, the analog-to-digital converter 100A may include a second DAC (DAC2) connected to the second comparator 102. In addition, the analog-to-digital converter 100A may include a third DAC (DAC3) connected to the third comparator 103.

Here, each of the first DAC (DAC1), the second DAC (DAC2), and the third DAC (DAC3) may sample the analog input signal (AS) and transmit the sampled analog input signal (AS) to the first comparator 101, the second comparator 102, and the third comparator 103. For example, the first DAC (DAC1) may sample the analog input signal (AS) and transmit the sampled analog input signal (AS) to the first comparator 101. In addition, the second DAC (DAC2) may sample the analog input signal (AS) and transmit the sampled analog input signal (AS) to the second comparator 102. In addition, the third DAC (DAC3) may sample the analog input signal (AS) and transmit the sampled analog input signal (AS) to the third comparator 103.

Here, the analog-to-digital converter 100A illustrated in FIG. 2 may be understood as an example of the analog-to-digital converter 100 illustrated in FIG. 1. That is, the analog-to-digital converter 100A illustrated in FIG. 2 may be understood as a configuration further including a first DAC (DAC1), a second DAC (DAC2), and a third DAC (DAC3) from the analog-to-digital converter 100 illustrated in FIG. 1. However, hereinafter, for convenience of description, the configuration of the analog-to-digital converter 100 shown in FIG. 1 will be described.

Referring to FIG. 1, the analog-to-digital converter 100 may include a first comparator 101, a second comparator 102, and a third comparator 103, which receive analog input signals (AS), respectively.

According to an embodiment, each of the first comparator 101, the second comparator 102, and the third comparator 103 may compare the analog input signal (AS) with a signal input from the control logic circuit 110.

More specifically, each of the first comparator 101, the second comparator 102, and the third comparator 103 may output a result of comparing the magnitude of the analog input signal (AS) with the magnitude of the signal input from the control logic circuit 110.

Each of the first comparator 101, the second comparator 102, and the third comparator 103 may output a bit having a value of "0" when the magnitude of the analog input signal (AS) is smaller than the magnitude of the signal input from the control logic circuit 110. In addition, when the magnitude of the analog input signal (AS) is greater than the magnitude of the signal input from the control logic circuit 110, each of the first comparator 101, the second comparator 102, and the third comparator 103 may output a bit having a value of "1".

For example, when the magnitude of the analog input signal (AS) is greater than the magnitude of the signal input to each of the first comparator 101, the second comparator 102, and the third comparator 103, each of the first comparator 101, the second comparator 102, and the third comparator 103 may output "1".

For another example, when the magnitude of the analog input signal (AS) has a value between a signal input to the first comparator 101 and a signal input to the second comparator 102, the first comparator 101 may output "1", the second comparator 102 may output "0", and the third comparator may output "0".

In addition, the analog-to-digital converter 100 may include a control logic circuit 110 electrically connected to the first comparator 101, the second comparator 102, and the third comparator 103.

The control logic circuit 110 may execute, for example, software (or a program) to control at least one other component (e.g., the first comparator 101, the second comparator 102, and the third comparator 103) of the analog-to-digital converter 100, and may perform various data processing or operations. The control logic circuit 110 may include a central processing unit or a microprocessor, and may control the overall operation of the analog-to-digital converter 100. Accordingly, it may be understood that an operation performed by the analog-to-digital converter 100 is performed under the control of the analog-to-digital converter 100.

According to an embodiment, the control logic circuit 110 may include an algorithm for obtaining the digital output (DS) from the analog input signal (AS). For example, the algorithm may be software code programmed in the control logic circuit 110. For another example, the algorithm may be hard code hard-coded in the control logic circuit 110, but is not limited thereto.

The control logic circuit 110 may output the digital output (DS) from the analog input signal (AS) according to an algorithm.

More specifically, the control logic circuit 110 may output the digital output (DS) from the analog input signal (AS) using the first comparator 101, the second comparator 102, and the third comparator 103.

The control logic circuit 110 may output the digital output (DS) corresponding to the analog input signal (AS) based on an output value including bits output from each of the first comparator 101, the second comparator 102, and the third comparator 103.

The control logic circuit 110 may output a digital output (DS) corresponding to the analog input signal (AS) in response to the clock signal (CK) including a plurality of clock cycles.

More specifically, the control logic circuit 110 may output at least some bits of the digital output (DS) corresponding to the analog input signal (AS) in response to each of the plurality of clock cycles included in the clock signal (CK).

According to an embodiment, the control logic circuit 110 may apply first comparison voltages having a first interval to the first comparator 101, the second comparator 102, and the third comparator 103 during the first clock cycle. Here, for example, the first interval may have a value equal to 1/4 of the power supply voltage (VDD). That is, the control logic circuit 110 may input signals having values of 1/4, 1/2, and 3/4 of the power supply voltage (VDD) to each of the first comparator 101, the second comparator 102, and the third comparator 103.

Furthermore, the control logic circuit 110 may obtain a first digital output composed of two bits based on a first output value including bits output from the first comparator 101, the second comparator 102, and the third comparator 103.

For example, when the first output value is "000", the control logic circuit 110 may output a first digital output having a value of "00". For another example, when the first output value is "011", the control logic circuit 110 may output a first digital output having a value of "10". Here, the first output value may be understood as a 3-bit output sequentially including bits output from the first comparator 101, the second comparator 102, and the third comparator 103.

That is, the control logic circuit 110 may obtain the first digital output composed of two bits by comparing the analog input signal (AS) with signals having values equal to 1/4, 1/2, and 3/4 of the power supply voltage, respectively.

In addition, the control logic circuit 110 may apply second comparison voltages having a second interval within a predetermined range to each of the first comparator 101, the second comparator 102, and the third comparator 103 during the second clock cycle. Here, for example, the second clock cycle may be understood as a clock cycle subsequent to the first clock cycle of the clock signal (CK).

In addition, the second interval may be understood as a value smaller than the first interval. For example, the second interval may have a value of 1/8 of the power supply voltage (VDD). In addition, for example, the specified range may be understood as a range of 3/8 to 5/8 of the power supply voltage. That is, the control logic circuit 110 may input signals having values of 3/8, 1/2, and 5/8 of the power supply voltage (VDD) to each of the first comparator 101, the second comparator 102, and the third comparator 103.

Furthermore, the control logic circuit 110 may determine whether the second output value including bits output from the first comparator 101, the second comparator 102, and the third comparator 103 has a value within a predetermined range.

For example, when the second output value output from the first comparator 101, the second comparator 102, and the third comparator 103 is "001" or "011", the control logic circuit 110 may determine that the second output value has a value within a predetermined range. Here, the second output value may be understood as a 3-bit output sequentially including bits output from the first comparator 101, the second comparator 102, and the third comparator 103.

When the second output value has a value within a predetermined range, the control logic circuit 110 may obtain a second digital output composed of three bits based on the second output value. For example, when the second output value is "001", the control logic circuit 110 may output a second digital output having a value of "011". For another example, when the first output value is "011", the control logic circuit 110 may output a second digital output having a value of "100".

That is, the control logic circuit 110 may obtain the second digital output including three bits by comparing the analog input signal (AS) with signals having values as much as 3/8, 1/2, and 5/8 of the power supply voltage, respectively.

Furthermore, the control logic circuit 110 may output a digital output (DS) including a first digital output and a second digital output. For example, when the first digital output is "01" and the second digital output is "011", the control logic circuit 110 may output a 5-bit digital output (DS) having a value of "01011".

In addition, the control logic circuit 110 may correct an offset of at least some of the first comparator 101, the second comparator 102, and the third comparator 103 during the third clock cycle in response to obtaining the second digital output during the second clock cycle. Here, the third clock cycle may be understood as a clock cycle subsequent to the second clock cycle among the clock signals (CK).

More specifically, in response to obtaining the second digital output during the second clock cycle, the control logic circuit 110 may apply the common mode voltage to the first comparator 101, the second comparator 102, and the third comparator 103 during the third clock cycle.

In addition, the control logic circuit 110 may further apply a correction voltage to a comparator that outputs a predetermined error value in response to the common mode voltage among the first comparator 101, the second comparator 102, and the third comparator 103.

For example, when the first comparator 101 outputs a predetermined error value "1" in response to the common mode voltage, the control logic circuit 110 may further apply a correction voltage to the correction transistor included in the first comparator 101.

That is, the control logic circuit 110 may apply a correction voltage to at least one of the first comparator 101, the second comparator 102, and the third comparator 103 to set the offset of each comparator to "0".

In addition, according to an embodiment, when the second output value output from the first comparator 101, the second comparator 102, and the third comparator 103 is "000" or "111", the control logic circuit 110 may determine that the second output value has a value other than a predetermined range.

The control logic circuit 110 may apply third comparison voltages having a first interval to the first comparator 101, the second comparator 102, and the third comparator 103 during the third clock cycle in response to the second output value having a value other than the specified range. Here, for example, the third comparison voltages may have the same value as the first comparison voltages. That is, the control logic circuit 110 may input signals having values of 1/4, 1/2, and 3/4 of the power supply voltage (VDD) to the first comparator 101, the second comparator 102, and the third comparator 103, respectively, in response to the second output value having a value other than the specified range.

Furthermore, the control logic circuit 110 may obtain a third digital output composed of three bits based on a third output value including bits output from the first comparator 101, the second comparator 102, and the third comparator 103, and the second output value. Here, the third output value may be understood as a 3-bit output sequentially including bits output from the first comparator 101, the second comparator 102, and the third comparator 103.

For example, when the second output value is "000" and the third output value is "001", the control logic circuit 110 may output a third digital output having a value of "001". For another example, when the second output value is "111" and the third output value is "111", the control logic circuit 110 may output a third digital output having a value of "111". For another example, when the second output value is "111" and the third output value is "001", the control logic circuit 110 may output a third digital output having a value of "101".

That is, when the second output value has a value other than the specified range, the control logic circuit 110 may obtain the third digital output composed of three bits based on the second output value and the third output value.

Furthermore, the control logic circuit 110 may output a digital output (DS) including a first digital output and a third digital output. For example, when the first digital output is "10" and the third digital output is "101", the control logic circuit 110 may output a 5-bit digital output (DS) having a value of "10101".

Referring to the above-described configurations, the control logic circuit 110 according to an embodiment may apply the first comparison voltages having the first interval to the first comparator 101, the second comparator 102, and the third comparator 103 during the first clock cycle to obtain the first digital output composed of two bits.

Furthermore, during the second clock cycle, the control logic circuit 110 may apply second comparison voltages having a second interval smaller than the first interval within a predetermined range to the first comparator 101, the second comparator 102, and the third comparator 103.

Here, when the second output value output as the second comparison voltages are applied has a value within a predetermined range, the control logic circuit 110 may obtain a second digital output composed of three bits based on the second output value.

Furthermore, the control logic circuit 110 may correct an offset of at least one of the first comparator 101, the second comparator 102, and the third comparator 103 during the third clock cycle in response to obtaining the second digital output during the second clock cycle.

That is, the control logic circuit 110 according to the present disclosure may obtain the digital output by applying the comparison voltages of the same interval during three clock cycles, and may obtain the digital output (DS) using a relatively small number of clock cycles and correct the offset of each comparator, compared to the case of correcting the offset of each comparator through an additional clock cycle.

Accordingly, the analog-to-digital converter 100 according to an embodiment of the invention may reduce the time required to convert the analog input signal (AS) into the digital output (DS).

In addition, referring to the above-described configurations, the control logic circuit 110 according to an embodiment may apply a common mode voltage to the first comparator 101, the second comparator 102, and the third comparator 103 to correct the offset of each comparator.

That is, the control logic circuit 110 according to the present disclosure may relatively accurately correct the offsets of the comparators included in the analog-to-digital converter 100, compared to the case of correcting the offsets of other comparators based on the output value of one comparator.

Accordingly, the analog-to-digital converter 100 according to an embodiment of the invention may reduce performance deterioration due to offsets of comparators in an operation of converting the analog input signal (AS) into the digital output (DS).

Accordingly, through the above-described configurations, the analog-to-digital converter 100 of the present disclosure may improve the performance of an operation of converting the analog input signal (AS) into the digital output (DS).

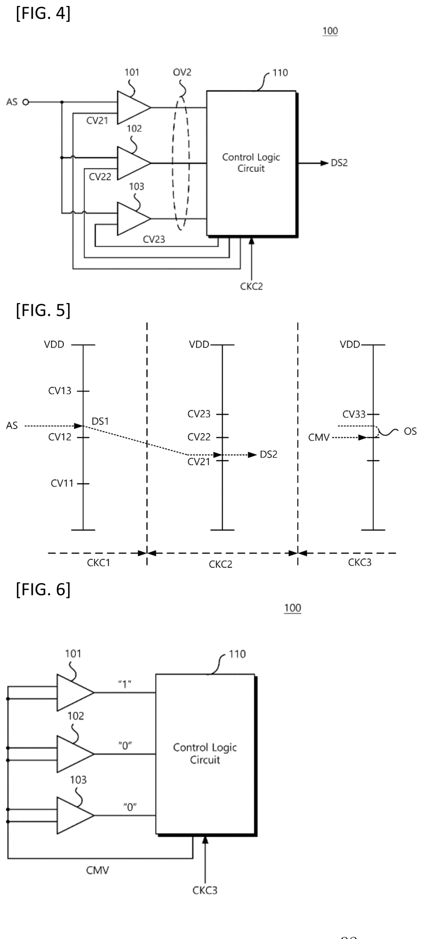

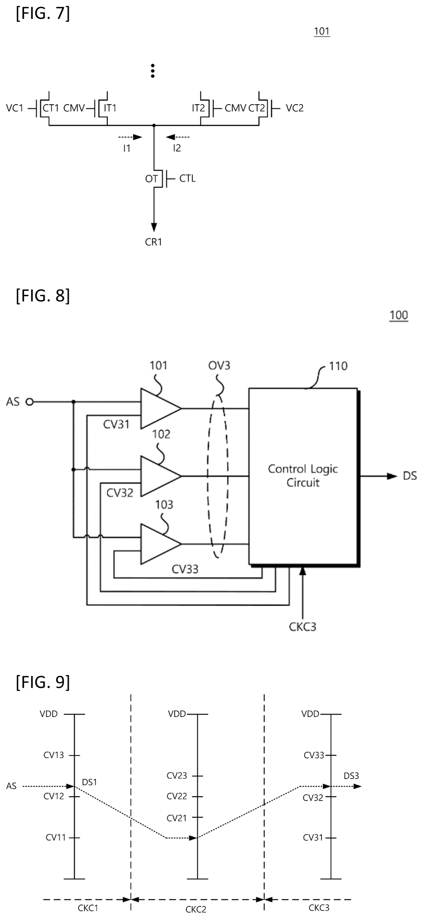

FIG. 3 illustrates a configuration in which a control logic circuit according to an embodiment obtains a first output value during a first clock cycle. FIG. 4 illustrates a configuration in which a control logic circuit according to an embodiment obtains a second output value during a second clock cycle. FIG. 5 illustrates a configuration in which a control logic circuit outputs a digital signal including a first digital output and a second digital output when a second output value has a value within a preset range according to an embodiment. FIG. 6 illustrates a configuration in which a control logic circuit according to an embodiment applies a common mode voltage to each of a first comparator to a third comparator during a third clock cycle. FIG. 7 illustrates a configuration for correcting an offset of a first comparator based on a correction output value output from the first comparator according to an embodiment.

Referring to FIGS. 3 to 5, the control logic circuit 110 according to an embodiment may output the digital output (DS) including the first digital output (DS1) and the second digital output (DS2) through the first clock cycle (CKC1) and the second clock cycle (CKC2).

More specifically, the control logic circuit 110 may output the digital output (DS) from the analog input signal (AS) using the first comparator 101, the second comparator 102, and the third comparator 103.

Referring to FIG. 3, the control logic circuit 110 according to an embodiment may apply first comparison voltages (CV11, CV12, and CV13) having a first interval to the first comparator 101, the second comparator 102, and the third comparator 103 during the first clock cycle (CKC1). Here, for example, the first interval may have a value equal to 1/4 of the power supply voltage (VDD).

Accordingly, the control logic circuit 110 may input the first comparison voltage (1) (CV11) having a value equal to 1/4 of the power supply voltage (VDD) to the first comparator 101. In addition, the control logic circuit 110 may input the first comparison voltage (2) (CV12) having a value equal to 1/2 of the power supply voltage (VDD) to the second comparator 102. In addition, the control logic circuit 110 may input the first comparison voltage (3) (CV13) having a value equal to 3/4 of the power supply voltage (VDD) to the third comparator 103.

Furthermore, the control logic circuit 110 may obtain the first digital output (DS1) including two bits based on the first output value (OV1) including bits output from the first comparator 101, the second comparator 102, and the third comparator 103.

For example, referring to FIG. 5, when the first output value (OV1) is "011", the control logic circuit 110 may output the first digital output (DS1) having a value of "10". Here, the first output value (OV1) may be understood as a 3-bit output sequentially including bits output from the first comparator 101, the second comparator 102, and the third comparator 103.

That is, the control logic circuit 110 may obtain the first digital output (DS1) including two bits by comparing the analog input signal (AS) with the first comparison voltages (CV11, CV12, and CV13) having values equal to 1/4, 1/2, and 3/4 of the power supply voltage (VDD), respectively.

In addition, referring to FIG. 4, the control logic circuit 110 may apply the second comparison voltages (CV21, CV22, and CV23) having the second interval within a predetermined range to each of the first comparator 101, the second comparator 102, and the third comparator 103 during the second clock cycle (CKC2). Here, for example, the second clock cycle (CKC2) may be understood as a clock cycle subsequent to the first clock cycle (CKC1).

In addition, the second interval may be understood as a value smaller than the first interval. For example, the second interval may have a value equal to 1/8 of the power supply voltage (VDD). In addition, for example, the specified range may be understood as a range of 3/8 to 5/8 of the power supply voltage (VDD).

Accordingly, the control logic circuit 110 may input the second comparison voltage (1) (CV21) having a value equal to 3/8 of the power supply voltage (VDD) to the first comparator 101. In addition, the control logic circuit 110 may input the second comparison voltage (2) (CV22) having a value equal to 1/2 of the power supply voltage (VDD) to the second comparator 102. In addition, the control logic circuit 110 may input the second comparison voltage (3) (CV23) having a value equal to 5/8 of the power supply voltage (VDD) to the third comparator 103.

Furthermore, the control logic circuit 110 may determine whether the second output value (OV2) including bits output from the first comparator 101, the second comparator 102, and the third comparator 103 has a value within a predetermined range.

For example, when the second output value (OV2) output from the first comparator 101, the second comparator 102, and the third comparator 103 is "001" or "011", the control logic circuit 110 may determine that the second output value (OV2) has a value within a predetermined range. Here, the second output value (OV2) may be understood as a 3-bit output sequentially including bits output from the first comparator 101, the second comparator 102, and the third comparator 103.

Referring to FIG. 4, when the second output value (OV2) has a value within a predetermined range, the control logic circuit 110 may obtain a second digital output (DS2) including three bits based on the second output value (OV2).

For example, referring to FIG. 5, when the second output value (OV2) is "001", the control logic circuit 110 may output the second digital output (DS2) of which the value is "011".

That is, the control logic circuit 110 may obtain the second digital output (DS2) including three bits by comparing the analog input signal (AS) with the second comparison voltages (CV21, CV22, and CV23) having values equal to 3/8, 1/2, and 5/8 of the power supply voltage (VDD), respectively.

Furthermore, the control logic circuit 110 may output a digital output (DS) including a first digital output (DS1) and a second digital output (DS2). For example, when the first digital output (DS1) is "10" and the second digital output (DS2) is "011", the control logic circuit 110 may output the 5-bit digital output (DS) having a value of "10011".

Referring to FIGS. 5 to 7 together, the control logic circuit 110 according to an embodiment may correct the offset (OS) of at least some of the first comparator 101, the second comparator 102, and the third comparator 103 during the third clock cycle (CKC3).

More specifically, in response to obtaining the second digital output (DS2) during the second clock cycle (CKC2), the control logic circuit 110 may correct the offset OS of at least some of the first comparator 101, the second comparator 102, and the third comparator 103 during the third clock cycle (CKC3). Here, the third clock cycle (CKC3) may be understood as a clock cycle subsequent to the second clock cycle (CKC2).

Referring to FIGS. 5 and 6, the control logic circuit 110 according to an embodiment may apply the common mode voltage (CMV) to each of the first comparator 101, the second comparator 102, and the third comparator 103 during the third clock cycle (CKC3) in response to obtaining the second digital output (DS2) during the second clock cycle (CKC2).

In addition, the control logic circuit 110 may further apply a correction voltage to a comparator that outputs a predetermined error value in response to the common mode voltage (CMV) among the first comparator 101, the second comparator 102, and the third comparator 103.

Referring to FIG. 6, when the first comparator 101 outputs a predetermined error value "1" in response to the common mode voltage (CMV), the control logic circuit 110 may correct the offset (OS) of the first comparator 101.

More specifically, referring to FIG. 7, the first comparator 101 according to an embodiment may include a plurality of internal transistors (IT1 and IT2), a plurality of correction transistors (CT1 and CT2), and an output transistor (OT).

The first comparator 101 may be connected in parallel with each other, and may include a first internal transistor (IT1) and a second internal transistor (IT2), which are operated by a common mode voltage (CMV), respectively.

In addition, the first comparator 101 may include a first correction transistor (CT1) operated by a first correction voltage (VC1) and a second correction transistor (CT2) operated by a second correction voltage (VC2).

Furthermore, the first comparator 101 may include an output transistor (OT) operated by an output control signal (CTL).

Here, the first comparator 101 may output the first comparison result (CR1) having a value of "0" when the first current (I1) flowing from the first correction transistor (CT1) and the first internal transistor (IT1) to the output transistor (OT) and the second current (12) flowing from the second correction transistor (CT2) and the second internal transistor (IT2) to the output transistor (OT) are the same.

For another example, when the values of the first current (11) and the second current (12) are different from each other, the first comparator 101 may output the first comparison result (CR1) having a value of "1".

Accordingly, as the common mode voltage (CMV) is applied to the first internal transistor (IT1) and the second internal transistor (IT2) of the first comparator 101, when the first comparator 101 outputs the first comparison result (CR1) having a value of "1", the control logic circuit 110 may control at least some of the first correction transistor (CT1) and the second correction transistor (CT2).

For example, when the first comparator 101 outputs "1" as the common mode voltage (CMV) is applied to the first comparator 101, the control logic circuit 110 may apply the first correction voltage (VC1) to the first correction transistor (CT1) such that the values of the first current (I1) and the second current (12) are the same.

That is, the control logic circuit 110 may control at least some of the first correction transistor (CT1) and the second correction transistor (CT2) such that the values of the first current (I1) and the second current (I2) input to the output transistor (OT) of the first comparator 101 are maintained to be the same.

Accordingly, the control logic circuit 110 according to an embodiment may apply a correction voltage to at least one of the first comparator 101, the second comparator 102, and the third comparator 103 to set the offset of each comparator to "0".

Referring to the above-described configurations, the control logic circuit 110 according to an embodiment may apply the first comparison voltages (CV11, CV12, and CV13) having the first interval to the first comparator 101, the second comparator 102, and the third comparator 103 during the first clock cycle (CKC1) to obtain the first digital output (DS1) including two bits.

Furthermore, during the second clock cycle (CKC2), the control logic circuit 110 may apply the second comparison voltages (CV21, CV22, and CV23) having a second interval smaller than the first interval within a predetermined range to each of the first comparator 101, the second comparator 102, and the third comparator 103.

Here, when the second output value (OV2) output as the second comparison voltages (CV21, CV22, and CV23) are applied has a value within a predetermined range, the control logic circuit 110 may obtain the second digital output (DS2) including three bits based on the second output value (OV2).

Furthermore, the control logic circuit 110 may correct the offset (OS) of at least one of the first comparator 101, the second comparator 102, and the third comparator 103 during the third clock cycle (CKC3) in response to obtaining the second digital output (DS2) during the second clock cycle (CKC2).

That is, the control logic circuit 110 according to the present disclosure may obtain the digital output by applying the comparison voltages of the same interval during three clock cycles, and may obtain the digital output (DS) using a relatively small clock cycle and correct the offset (OS) of each comparator, compared to the case of correcting the offset of each comparator through an additional clock cycle.

Accordingly, the analog-to-digital converter 100 according to an embodiment of the inventive concept may reduce the time required to convert the analog input signal (AS) into the digital output (DS).

In addition, referring to the above-described configurations, the control logic circuit 110 according to an embodiment may correct the offset of each comparator by applying the common mode voltage (CMV) to the first comparator 101, the second comparator 102, and the third comparator 103.

That is, the control logic circuit 110 according to the inventive concept may correct the offsets (OS) of the comparators included in the analog-to-digital converter 100 relatively accurately compared to the case of correcting the offsets of other comparators based on the output value of one comparator.

Accordingly, the analog-to-digital converter 100 according to an embodiment of the inventive concept may reduce performance deterioration due to the offset (OS) of the comparators in the operation of converting the analog input signal (AS) into the digital output (DS).

Accordingly, through the above-described configurations, the analog-to-digital converter 100 of the present disclosure may improve the performance of an operation of converting the analog input signal (AS) into the digital output (DS).

FIG. 8 illustrates a configuration in which a control logic circuit obtains a third output value during a third clock cycle when a second output value has a value outside a preset range according to an embodiment. FIG. 9 illustrates a configuration in which a control logic circuit according to an embodiment outputs a digital signal based on a second output value and a third output value.

Referring to FIGS. 8 and 9 together, when the second output value (OV2) has a value other than a predetermined range, the control logic circuit 110 according to an embodiment may obtain the third digital output (DS3) through the third clock cycle (CKC3).

According to an embodiment, the control logic circuit 110 may determine whether the second output value (OV2) has a value other than a predetermined range.

For example, when the second output value (OV2) output from the first comparator 101, the second comparator 102, and the third comparator 103 is "000" or "111", the control logic circuit 110 may determine that the second output value (OV2) has a value other than a predetermined range.

The control logic circuit 110 may apply the third comparison voltages (CV31, CV32, and CV33) having the first interval to the first comparator 101, the second comparator 102, and the third comparator 103 during the third clock cycle (CKC3) in response to the second output value (OV2) having a value other than the specified range. Here, for example, the third comparison voltages (CV31, CV32, and CV33) may have the same value as the first comparison voltages (CV11, CV12, and CV13).

Accordingly, the control logic circuit 110 may input the third comparison voltage (1) (CV31) having a value equal to 1/4 of the power supply voltage (VDD) to the first comparator 101. In addition, the control logic circuit 110 may input the third comparison voltage (2) (CV32) having a value equal to 1/2 of the power supply voltage (VDD) to the second comparator 102. In addition, the control logic circuit 110 may input the third comparison voltage (3) (CV33) having a value equal to 3/4 of the power supply voltage (VDD) to the third comparator 103.

Furthermore, the control logic circuit 110 may obtain the third digital output (DS3) including three bits based on the third output value (OV3) including the bits output from the first comparator 101, the second comparator 102, and the third comparator 103, and the second output value (OV2). Here, the third output value (OV3) may be understood as a 3-bit output sequentially including bits output from the first comparator 101, the second comparator 102, and the third comparator 103.

For example, referring to FIG. 9, when the second output value (OV2) is "000" and the third output value OV3 is "011", the control logic circuit 110 may output the third digital output (DS3) having a value of "010".

That is, when the second output value (OV2) has a value outside the specified range, the control logic circuit 110 may obtain the third digital output (DS3) including three bits based on the second output value (OV2) and the third output value (OV3).

Furthermore, the control logic circuit 110 may output a digital output (DS) including a first digital output (DS1) and a third digital output (DS3). For example, when the first digital output (DS1) is "10" and the third digital output (DS3) is "010", the control logic circuit 110 may output the 5-bit digital output (DS) having a value of "10010".

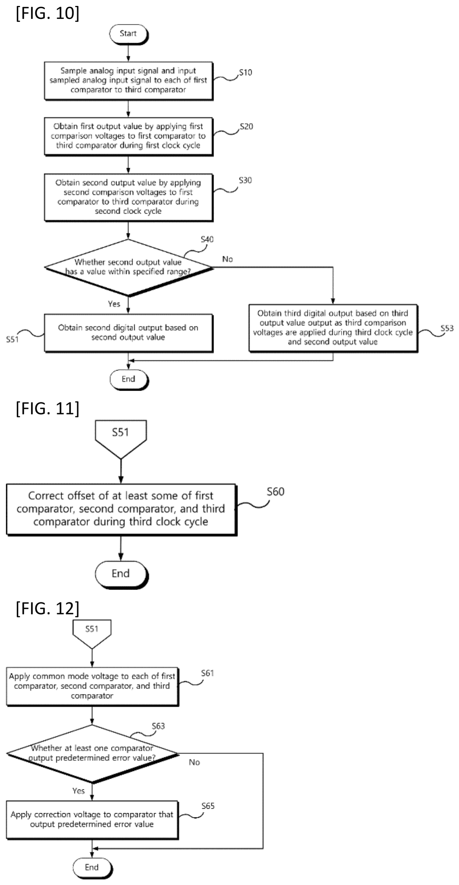

FIG. 10 is a flowchart illustrating a method of operating the analog-to-digital converter according to an embodiment. FIG. 11 is a flowchart illustrating the method of correcting an offset of at least one of a first comparator to a third comparator during a third clock cycle according to an embodiment. FIG. 12 is a flowchart illustrating the more specific method of correcting an offset of at least one of a first comparator to a third comparator during a third clock cycle according to an embodiment.

Referring to FIGS. 10 to 12 together, the control logic circuit 110 (or the analog-to-digital converter 100) according to an embodiment may output at least some bits of the digital output (DS) corresponding to the analog input signal (AS) in response to each of the plurality of clock cycles (CKC1, (CKC2, and (CKC3) included in the clock signal (CK).

In step S10, the control logic circuit 110 according to an embodiment may sample the analog input signal (AS) and input the sampled analog input signal (AS) to each of the first comparator 101, the second comparator 102, and the third comparator 103.

More specifically, the control logic circuit 110 may sample the analog input signal (AS) using the first DAC (DAC1), the second DAC (DAC2), and the third DAC (DAC3) and input the sampled analog input signal (AS) to each of the first comparator 101, the second comparator 102, and the third comparator 103.

In operation S20, the control logic circuit 110 according to an embodiment may apply first comparison voltages (CV11, CV12, and CV13) having a first interval to the first comparator 101, the second comparator 102, and the third comparator 103 during the first clock cycle (CKC1). Here, for example, the first interval may have a value equal to 1/4 of the power supply voltage (VDD).

That is, the control logic circuit 110 may respectively input the first comparison voltages (CV11, CV12, and CV13) having values equal to 1/4, 1/2, and 3/4 of the power supply voltage (VDD) to the first comparator 101, the second comparator 102, and the third comparator 103.

Furthermore, the control logic circuit 110 may obtain the first digital output (DS1) including two bits based on the first output value (OV1) including bits output from the first comparator 101, the second comparator 102, and the third comparator 103.

For example, when the first output value (OV1) is "011", the control logic circuit 110 may output the first digital output (DS1) having a value of "10".

That is, the control logic circuit 110 may obtain the first digital output (DS1) including two bits by comparing the analog input signal (AS) with the first comparison voltages (CV11, CV12, and CV13) having values equal to 1/4, 1/2, and 3/4 of the power supply voltage (VDD), respectively.

In step S30, the control logic circuit 110 according to an embodiment may apply the second comparison voltages (CV21, CV22, and CV23) having the second interval to each of the first comparator 101, the second comparator 102, and the third comparator 103.

More specifically, during the second clock cycle (CKC2), the control logic circuit 110 may apply the second comparison voltages (CV21, CV22, and CV23) having the second interval within a predetermined range to each of the first comparator 101, the second comparator 102, and the third comparator 103. Here, for example, the second clock cycle (CKC2) may be understood as a clock cycle subsequent to the first clock cycle (CKC1).

In addition, the second interval may be understood as a value smaller than the first interval. For example, the second interval may have a value equal to 1/8 of the power supply voltage (VDD). In addition, for example, the specified range may be understood as a range of 3/8 to 5/8 of the power supply voltage (VDD).

That is, the control logic circuit 110 may input the second comparison voltages (CV21, CV22, and CV23) having values corresponding to 3/8, 1/2, and 5/8 of the power supply voltage (VDD) to the first comparator 101, the second comparator 102, and the third comparator 103, respectively.

Furthermore, in step S40, the control logic circuit 110 according to an embodiment may determine whether the second output value (OV2) has a value within a specified range.

More specifically, the control logic circuit 110 may determine whether the second output value (OV2) including bits output from the first comparator 101, the second comparator 102, and the third comparator 103 has a value within a predetermined range.

For example, when the second output value (OV2) output from the first comparator 101, the second comparator 102, and the third comparator 103 is "001" or "011", the control logic circuit 110 may determine that the second output value (OV2) has a value within a predetermined range.

In step S51, when the second output value (OV2) has a value within a predetermined range, the control logic circuit 110 may obtain the second digital output (DS2) including three bits based on the second output value (OV2).

For example, when the second output value (OV2) is "001", the control logic circuit 110 may output the second digital output (DS2) of which the value is "011".

That is, the control logic circuit 110 may obtain the second digital output (DS2) including three bits by comparing the analog input signal (AS) with the second comparison voltages (CV21, CV22, and CV23) having values equal to 3/8, 1/2, and 5/8 of the power supply voltage (VDD), respectively.

Furthermore, the control logic circuit 110 may output a digital output (DS) including a first digital output (DS1) and a second digital output (DS2). For example, when the first digital output (DS1) is "10" and the second digital output (DS2) is "011", the control logic circuit 110 may output the 5-bit digital output (DS) having a value of "10011".

In step S53, according to another embodiment, when the second output value (OV2) has a value other than the predetermined range, the third digital output (DS3) may be obtained based on the third output value (OV3) output as the third comparison voltages (CV31, CV32, and CV33) are applied during the third clock cycle (CKC3) and the second output value (OV2).

For example, when the second output value (OV2) output from the first comparator 101, the second comparator 102, and the third comparator 103 is "000" or "111", the control logic circuit 110 may determine that the second output value (OV2) has a value other than a predetermined range.

The control logic circuit 110 may apply the third comparison voltages (CV31, CV32, and CV33) having the first interval to the first comparator 101, the second comparator 102, and the third comparator 103 during the third clock cycle (CKC3) in response to the second output value (OV2) having a value other than the specified range. Here, for example, the third comparison voltages (CV31, CV32, and CV33) may have the same value as the first comparison voltages (CV11, CV12, and CV13).

That is, the control logic circuit 110 may respectively input the third comparison voltages (CV31, CV32, and CV33) having values equal to 1/4, 1/2, and 3/4 of the power supply voltage (VDD) to the first comparator 101, the second comparator 102, and the third comparator 103.

Furthermore, the control logic circuit 110 may obtain the third digital output (DS3) including three bits based on the third output value (OV3) including the bits output from the first comparator 101, the second comparator 102, and the third comparator 103, and the second output value (OV2).

For example, when the second output value (OV2) is "000" and the third output value (OV3) is "011", the control logic circuit 110 may output the third digital output (DS3) having a value of "010".

That is, when the second output value (OV2) has a value outside the specified range, the control logic circuit 110 may obtain the third digital output (DS3) including three bits based on the second output value (OV2) and the third output value (OV3).

Furthermore, the control logic circuit 110 may output a digital output (DS) including a first digital output (DS1) and a third digital output (DS3). For example, when the first digital output (DS1) is "10" and the third digital output (DS3) is "010", the control logic circuit 110 may output the 5-bit digital output (DS) having a value of "10010".

Referring to FIGS. 11 and 12 together, the control logic circuit 110 according to an embodiment may correct an offset (OS) of at least some of the first comparator 101, the second comparator 102, and the third comparator 103.

Referring to FIG. 11, in step S60, the control logic circuit 110 according to an embodiment may correct an offset (OS) of at least some of the first comparator 101, the second comparator 102, and the third comparator 103 during the third clock cycle (CKC3) in response to obtaining the second digital output (DS2) through the second clock cycle (CKC2).

More specifically, referring to FIG. 12, the control logic circuit 110 according to an embodiment may correct the offset (OS) of at least some of the first comparator 101, the second comparator 102, and the third comparator 103 by applying the common mode voltage (CMV) to the first comparator 101, the second comparator 102, and the third comparator 103.

In step S61, the control logic circuit 110 according to an embodiment may apply the common mode voltage (CMV) to each of the first comparator 101, the second comparator 102, and the third comparator 103.

More specifically, in response to obtaining the second digital output (DS2) during the second clock cycle (CKC2), the control logic circuit 110 may apply the common mode voltage (CMV) to each of the first comparator 101, the second comparator 102, and the third comparator 103 during the third clock cycle (CKC3).

In step S63, the control logic circuit 110 according to an embodiment may determine whether at least one of the first comparator 101, the second comparator 102, and the third comparator 103 outputs a predetermined error value (e.g., "1").

For example, the control logic circuit 110 may determine whether the first comparator 101 outputs a predetermined error value (e.g., "1").

Furthermore, in step S65, the control logic circuit 110 according to an embodiment may apply a correction voltage to a comparator that outputs a predetermined error value "1" in response to the common mode voltage (CMV).

For example, when the first comparator 101 outputs a predetermined error value "1" in response to the common mode voltage (CMV), the control logic circuit 110 may further apply a correction voltage to the correction transistor included in the first comparator 101.

That is, the control logic circuit 110 may apply a correction voltage to at least one of the first comparator 101, the second comparator 102, and the third comparator 103 to set the offset of each comparator to "0".

Referring to the above-described configurations, the control logic circuit 110 according to an embodiment may obtain the first digital output (DS1) including two bits by applying the first comparison voltages (CV11, CV12, and CV13) having the first interval to the first comparator 101, the second comparator 102, and the third comparator 103 during the first clock cycle (CKC1).

Furthermore, during the second clock cycle (CKC2), the control logic circuit 110 may apply the second comparison voltages (CV21, CV22, and CV23) having a second interval smaller than the first interval within a predetermined range to each of the first comparator 101, the second comparator 102, and the third comparator 103.

Here, when the second output value (OV2) output as the second comparison voltages (CV21, CV22, and CV23) are applied has a value within a predetermined range, the control logic circuit 110 may obtain the second digital output (DS2) including three bits based on the second output value (OV2).

Furthermore, the control logic circuit 110 may correct the offset OS of at least one of the first comparator 101, the second comparator 102, and the third comparator 103 during the third clock cycle (CKC3) in response to obtaining the second digital output (DS2) during the second clock cycle (CKC2).

That is, the control logic circuit 110 according to the present disclosure may obtain the digital output by applying the comparison voltages of the same interval during three clock cycles, and may obtain the digital output (DS) using a relatively small clock cycle and correct the offset (OS) of each comparator, compared to the case of correcting the offset of each comparator through an additional clock cycle.

Accordingly, the analog-to-digital converter 100 according to an embodiment of the inventive concept may reduce the time required to convert the analog input signal (AS) into the digital output (DS).

In addition, referring to the above-described configurations, the control logic circuit 110 according to an embodiment may correct the offset of each comparator by applying the common mode voltage (CMV) to the first comparator 101, the second comparator 102, and the third comparator 103.

That is, the control logic circuit 110 according to the inventive concept may correct the offsets (OS) of the comparators included in the analog-to-digital converter 100 relatively accurately compared to the case of correcting the offsets of other comparators based on the output value of one comparator.

Accordingly, the analog-to-digital converter 100 according to an embodiment of the inventive concept may reduce performance deterioration due to the offset (OS) of the comparators in the operation of converting the analog input signal (AS) into the digital output (DS).

Accordingly, through the above-described configurations, the analog-to-digital converter 100 of the present disclosure may improve the performance of an operation of converting the analog input signal (AS) into the digital output (DS).

As described above, although the present invention has been described with reference to the accompanying drawings, the present invention is not limited by the embodiments and drawings disclosed in the present specification, and it is obvious that various modifications may be made by a person skilled in the art within the scope of the technical idea of the present invention. In addition, although the effects according to the configuration of the present invention are not explicitly described and described while describing the embodiments of the present invention, it is natural that the effects predictable by the corresponding configuration should also be recognized.

This work was supported by the National Research Foundation of Korea (NRF) grate funded by the Korea government (MSIT) (No. RS-2023-0281047).

### [Description of Reference Numerals]

100: Analog-to-digital converter
101: First comparator
102: Second comparator
103: Third comparator
110: Control logic circuit

## Claims

1. A method of operating an analog-to-digital converter for converting an analog input signal into a digital output in response to a clock cycle, the method comprising: sampling the analog input signal and inputting the sampled analog input signal to each of a first comparator, a second comparator, and a third comparator;obtaining a first digital output including two bits based on a first output value output as first comparison voltages having a first interval are applied to the first comparator to the third comparator during a first clock cycle;obtaining a second output value by applying second comparison voltages having a second interval smaller than the first interval to the first comparator to the third comparator within a preset range during a second clock cycle; and obtaining a second digital output including three bits based on the second output value when the second output value has a value within the range.

2. The method of claim 1, wherein the obtaining of the first digital output during the first clock cycle further comprises: applying a first comparison voltage (1) to the first comparator, applying a first comparison voltage (2) having the first interval from the first comparison voltage (1) to the second comparator, and applying a first comparison voltage (3) having the first interval from the first comparison voltage (2) to the third comparator; and obtaining the first digital output corresponding to the first output value including comparison results output from the first comparator to the third comparator, wherein the first interval has a value equal to 1/4 of a power supply voltage.

3. The method of claim 2, wherein the obtaining of the second digital output during the second clock cycle further comprises: applying a second comparison voltage (1) to the first comparator, applying a second comparison voltage (2) to the second comparator, and applying a second comparison voltage (3) to the third comparator; and obtaining the second digital output corresponding to the second output value including comparison results output from the first comparator to the third comparator, wherein the second interval has a value equal to 1/8 of the power supply voltage.

4. The method of claim 2, further comprising: in response to obtaining the second digital output during the second clock cycle, correcting an offset of at least one of the first comparator to the third comparator during a third clock cycle.

5. The method of claim 4, wherein the correcting of the offset of at least one of the first comparator to the third comparator further comprises: applying a common mode voltage to each of the first comparator to the third comparator; and further applying a correction voltage to the first comparator such that the first comparator outputs a predetermined normal value when the first comparator outputs a predetermined error value.

6. The method of claim 4, further comprising: applying third comparison voltages having the first interval to the first comparator to the third comparator during the third clock cycle when the second output value has a value outside the range; and determining a third digital output including three bits based on a third output value output from the first comparator to the third comparator during the third clock cycle and the second output value.

7. An analog-to-digital converter comprising: a first comparator, a second comparator, and a third comparator; and a control logic circuit configured to output a digital output from an analog input signal using the first comparator to the third comparator based on a clock cycle, wherein the control logic circuit is configured to: obtain a first digital output consisting of two bits based on a first output value output as first comparison voltages having a first interval are applied to the first comparator to the third comparator during a first clock cycle; obtain a second digital output consisting of three bits based on the second output value when a second output value output as second comparison voltages having a second interval smaller than the first interval are applied to the first comparator to the third comparator within a predetermined range during a second clock cycle has a value within the range; and in response to obtaining the second digital output during the second clock cycle, perform offset correction of at least a portion of the first to third comparators during a third clock cycle.

8. The analog-to-digital converter of claim 7, wherein the first interval has a value as much as 1/4 of a power supply voltage, and the second interval has a value as much as 1/8 of the power supply voltage.

9. The analog-to-digital converter of claim 7, wherein the control logic circuit is configured to: when the second output value has a value outside the range, apply third comparison voltages having the first interval to the first comparator to the third comparator during the third clock cycle, and obtain a third digital output including three bits based on a third output value output as the third comparison voltages are applied, and the second output value.

10. The analog-to-digital converter of claim 7, wherein the control logic circuit is further configured to: apply a common mode voltage to each of the first comparator to the third comparator during the third clock cycle in response to obtaining the second digital output during the second clock cycle, and further apply a correction voltage to the first comparator such that the first comparator outputs a predetermined normal value when the first comparator outputs a predetermined error value.
